# EUROPEAN PATENT SPECIFICATION

(11) **EP 0 350 011 B1**
(45) Date of publication and mention of the grant of the patent: **12.05.1993**
(21) Application number: 89112282.2
(22) Date of filing: 05.07.1989
(51) Int. Cl.: H01L 25/16, H01L 23/14

(54) **Hermetic hybrid film circuit assembly with unpackaged active components and process for its fabrication**
Hermetisch abgeschlossener Hybrid-Film-Schaltungsaufbau mit unbedeckten aktiven Bausteinen und Verfahren zu dessen Herstellung
Assemblage hermétique de circuits hybrides à film comprenant des composants actifs non encapsulés et procédé pour sa fabrication

(30) Priority: 07.07.1988 IT 2126988
(43) Date of publication of application: 10.01.1990
(73) Proprietor: ALCATEL ITALIA Società per Azioni, 20149 Milano (IT)
(72) Inventor: Villa, Samuel, S. Donato Milanese (MI) (IT)
(74) Representative: Strehl Schübel-Hopf Groening & Partner

(56) References cited:
- FR-A- 2 507 409
- PATENT ABSTRACTS OF JAPAN vol. 10, no. 275 (E-438)(2331) 18 September 1986, & JP-A-61 96753

## Description

The present invention relates, according to claim 1, to hybrid film circuits having on a first face the passive electronic network and fixed to a metallic support or to the other face the active component(s) made-up of "unpackaged chip(s)" connected to the network on the first face by means of metallized holes, e.g. blind holes.

The process for the assembling and hermetization of the above mentioned circuits, according to claim 5, includes substantially the following steps:
- Fastening e.g. by welding the film circuit onto the support, e.g. metallic support
- Fastening e.g. by resin or welding etc. the active component(s)
- Connecting the active component(s)
- Hermetization (sealing) of the active component(s)
- Control of "fine and gross leak" hermetization.

The present invention refers to hybrid film circuits with unpackaged active components and process for its assembling and hermetization. The invention makes use of the hybrid film circuits that employ blind metalized holes or holes to be closed for connecting the electronic passive network, made on the superior face of the circuit, with the other face, on which some pads are made for the fastening and connection of active component(s). Successively this circuit is fixed (e.g. welded) onto a support (e.g. metallic support), on which it was made by machine tool at least a seat that acts as "package" for the unpackaged active components and that is closed in the following by a welded cover.

Further the invention includes a process particularly advantageous, and therefore preferred for the fulfilment of "packages" for monolithic integrated circuits, e.g. on GaAs (MMICs).

It is well-known the wide use of hybrid film circuits in the electronic field and above all in the field of Telecommunications. As described by A. Bellardo and S. Villa at the 5th European IHSM, May 1985, in the work "Reliability results for different active component packaging solutions for hybrid circuits", in the construction of these circuits the selection of the solution of "packaging" and of the technics of interconnecting the active components have an extreme importance, whereby there is a direct consequence onto the purchase cost, reliability and performances of the systems. One of the interconnection technics for the active components, that is widely diffusing in these last years, above all for the fulfilment of hybrid film circuits for microwaves and monolithic integrated circuits for microwaves on GaAs, is the technics named "chip and wire". It consists in the assembly of the unpackaged active component (after the separation from the wafer) directly on the film circuit and/or on a mechanical structure, allowing the removing of the parasitic elements, usually introduced by the use of a "package".

While this technique must be considered established and standardized in the Art at all levels, the same consolidation cannot be affirmed surely as regards the related "packaging" technics that can be changed according to the applications and/or used component. In the construction of hybrid film circuits and monolithic integrated circuits, e.g. for the applications in microwave field, the problems of "packaging" are traditionally solved by means of the use of particular "packages", specifically conceived according to the uses, and that can be made of:
METAL (see e.g. MSN&CT September 86 "Amplifiers designed for future ECM and C³I applications"),
CERAMICS (see e.g. MSN&CT January 88 "High performance 20 GHz package for GaAs MMICs"), or
CERAMICS + METAL (see e.g. "Microwave Journal, November 86 "Microwave packages are meeting GaAs challenges").

These "packages", owing to their specialization can be considered as "custom" type, and develop the function of real housings that are hermetically closed after having inserted therein the passive electronic network and the unpackaged active components. It occurs that the hybrid film circuits made in this manner present: a very high cost, a low mechanical standardization, difficulty of interfacing many circuits; and in the case of hybrid circuit, e.g. for microwaves, the complete unaccessibility to the passive electronic network after the package closing.

The first object of the invention is that of providing hybrid film circuits and monolithic integrated circuits that do not show the above mentioned drawbacks and in particular allow the hermetization of the unpackaged active components without using a "package" and leave uncovered the electronic passive network. Another object of the present invention is to provide the fulfilment of hybrid film circuits, whose particular configuration allows high, mechanical and feeding terminal standardizations, that allows the connection towards other circuits using the normal welding technics. The main characteristics of the circuits according to the invention can be resumed in the following ones:
- reduced dimensions
- high mechanical and feeding terminal standardizations
- hermetically closed active components
- always accessible passive electronic network
- low cost of the hybrid film circuits
- easy replacement of the circuit also in "field".

This invention is particularly suitable for the fulfilment of hybrid film circuits for microwaves and monolithic integrated circuits on GaAs, that show the following (and other) interesting characteristics:
- High repeatibility of circuits
- Reduction of the cost of circuits and RF test times
- Hermetically closed active components
- Accessibility to the passive microwave network even after the hermetization of unpackaged active component(s), therefore the RF test must be not made in dedusted ambient
- Joinable directly to other hybrid film circuits without transitions
- Calibration (RF-sintonization) of the circuits singularly and/or in cascade with other circuits with the possibility of being realigned (calibrated) in any moment
- Simplifying the mechanical parts that holds the above mentioned circuits.

The invention shall be described with reference to an embodiment represented in the annexed drawings, in which:
- The Figure 1 is a schematic view in exploded perspective of a embodiment of the invention, in which the unpackaged component is fixed in the seat machined into the mechanical support (application for high powers); the Figures 1A and 1B are perspective partially sectioned views of the assembled circuit illustrated in Figure 1;
- The Figure 2 is a schematic perspective exploded view of the invention (similar to the Figure 1) with the variant of the active component fixed directly to the rear side of the hybrid film circuit (application for low powers);
- The Figure 2A is a schematic perspective partially sectioned view of the circuit illustrated in Figure 2 in the assembled condition.

The characteristics and advantages of the present invention shall be better understood with reference (as not limiting example) to the parts that form the invention and the main phases of the fabrication process, identifying them by means of the above mentioned drawings 1-1A-1B and 2-2A.

The circuits according to the invention are formed substantially by the following parts:
1 Hybrid film circuit (CF)
2 Metallic support (SM)
3 Unpackaged active component (CHIP)
4 Closing cap (CAP)

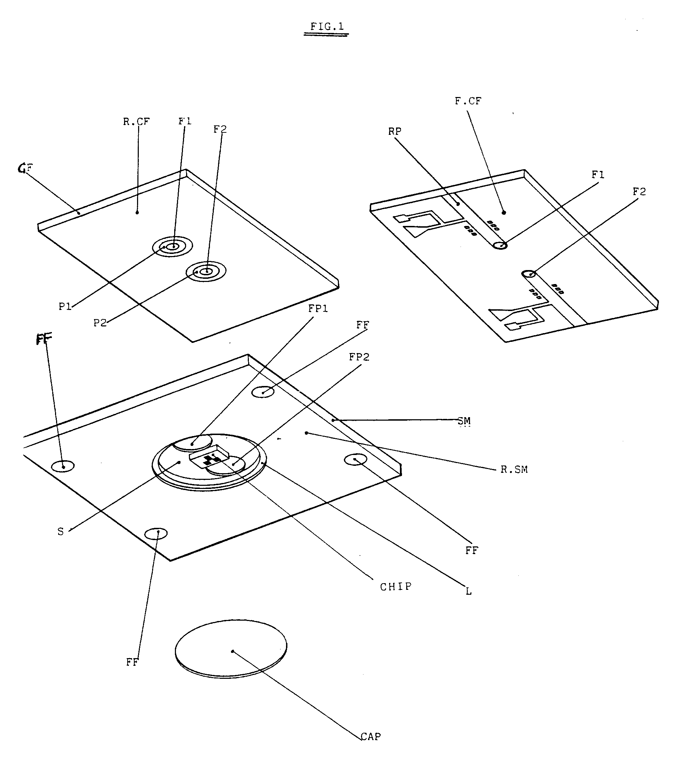

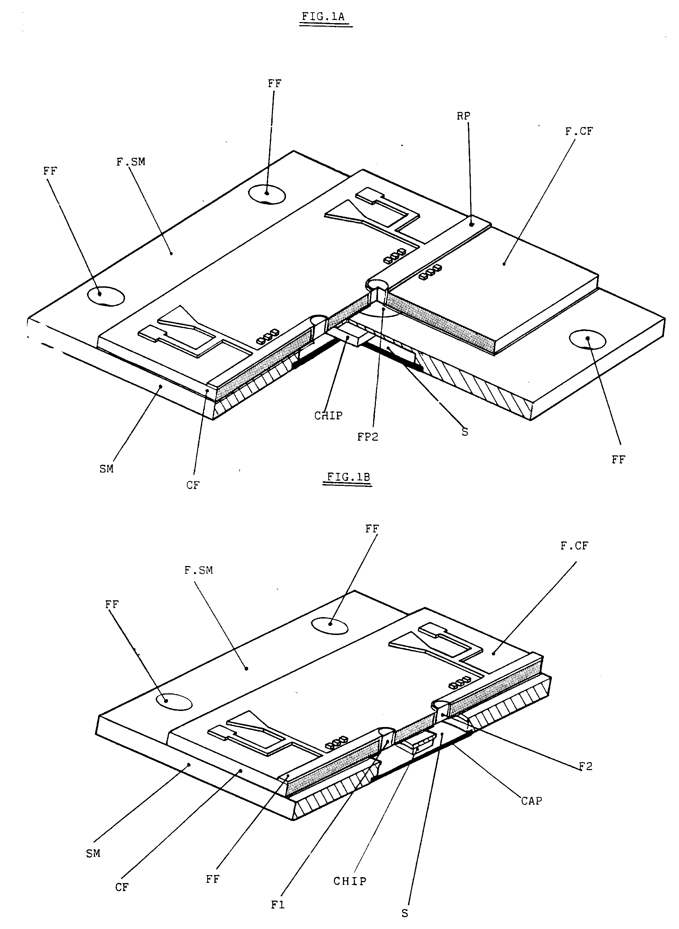

1) The hybrid film circuit that can be fabricated onto an isolating support, made e.g. of Al₂O₄, BeO, ALN, quartz, ferrite, etc. by means of photolithography or printing, uses the metalized holes, e.g. F1 anf F2, blind or to be closed, for connecting the passive electronic network RP, made on the front side of the hybrid film circuit F.CF, to the rear side of the hybrid film circuit R.CF, on which were formed connection pads, e.g. P1 and P2 insulated from the remainder part of the hybrid film circuit CF for the connection of the active component CHIP (Figure 1).
2) The support SM for the hybrid film circuit CF that can be made of metal, presents at least a seat S, e.g. of circular form, that acts contemporaneously as housing and as "die pad" (welding pad) for the fastening of the unpackaged component CHIP.
   The seat S is formed with through holes, e.g. FP1 and FP2, through which it is possible to have an access to the pads P1 and P2 in the rear side of the hybrid film circuit R.CF for the connection of the active component CHIP; on the rear part of the support R.SM it is made a spot-facing L concentric to the seat S for the housing of the cover CAP, Figure 1.

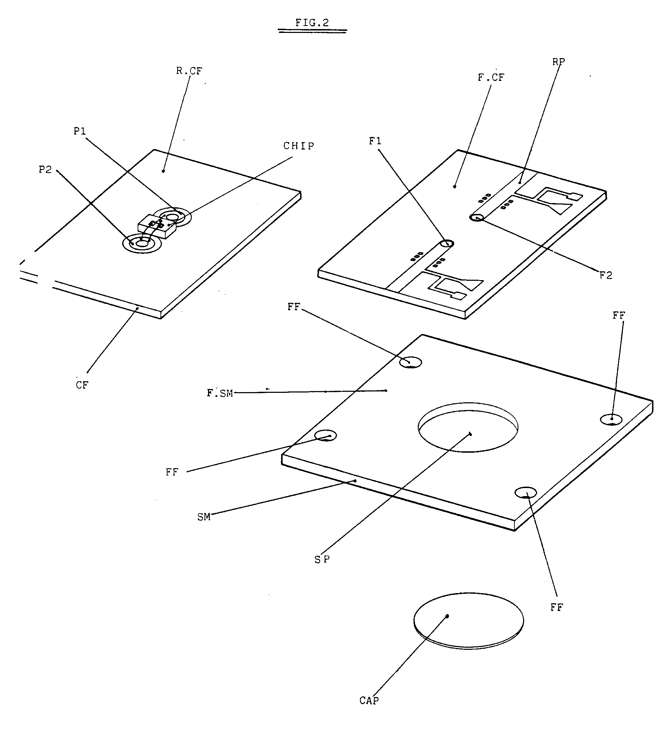

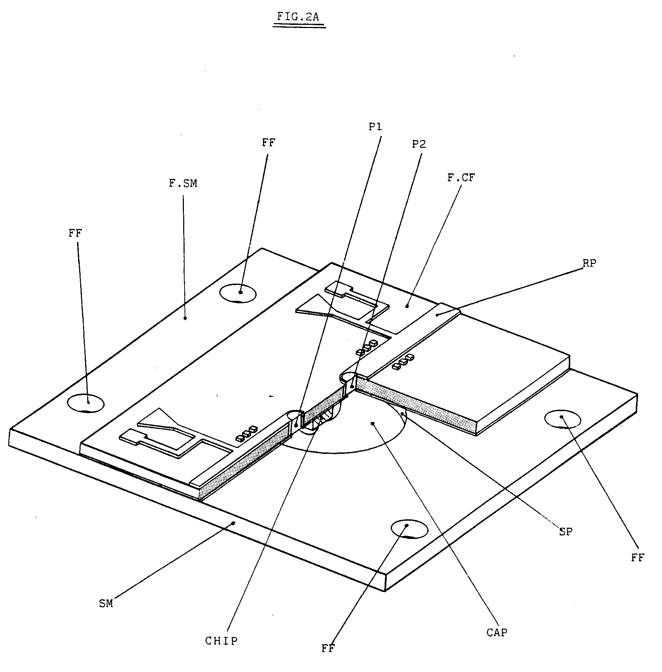

   The Figure 2 illustrates a variant in which the seat SP is through for allowing that the unpackaged active component CHIP is fixed in rear side of the hybrid film circuit R.CF. Even if it is not visible, the support SM of Figure 2 shows the same spot-facing of Figure 1. The supports SM of Figure 1 and Figure 2 show many through holes, e.g. 4 holes FF, for the fastening of the hybrid film circuit. The galvanic surface fininshing of the supports SM shall be preferably made of Ag or Au.
3) For the fulfilment of the hybrid circuits object of the invention it shall be used all unpackaged active components CHIP (Naked chip) normally used for the fulfilment of electronic and optoelectronic circuits.
4) The cover CAP illustrated in Figure 1 and 2 can be indifferently of the ceramic or metallic type, to be welded, e.g. by remelting, electrically, by laser, etc..

The main phases of the fabbrication process of hybrid circuits forming the object of the invention, are mainly carried out in the following manner:
A) Fastening, e.g. by Au/Sn or Au/Ge or Cu-Ag eutectic alloys, the film circuit rear side R.CF in the front side of the support F.SM, so that the pads P1 and P2 foreseen on the rear part of the hybrid film circuit R.CF are centered onto the holes FP1 and FP2 made in the support SM.
B) Closing, e.g. by alloy and/or welded metallic disks or cylinders, the metallized holes F1 and F2 of the hybrid film circuit CF; the variant of the hybrid film circuits made by printing (thick film circuits) the holes F1 and F2 of the above mentioned circuit can be already closed.
C) Fastening, e.g. by resin or by welding, the active component CHIP into the seat S foreseen on the rear side of the support R.SM. The Figures 2 and 2A show the variant of the active component CHIP fixed directly to the rear side of the hybrid film circuit R.CF.
D) Connecting by means of "wire bonding" the active device CHIP to the relevant flat zones P1 and P2 placed on the rear side of the hybrid film circuit R.CF. The Figures 1, 1A and 1B show the connection of the unpackaged active device CHIP to the relevant flat zones P1 and P2 placed on the rear side of the hybrid film circuit R.CF, where the wires pass through the holes FP1 and FP2 of the support SM.
E) Closing hermetically the seat S and/or SP of the variant of Figure 2, e.g. welding the cover CAP onto the spot-facing L machined on the rear side of the support R.SM.

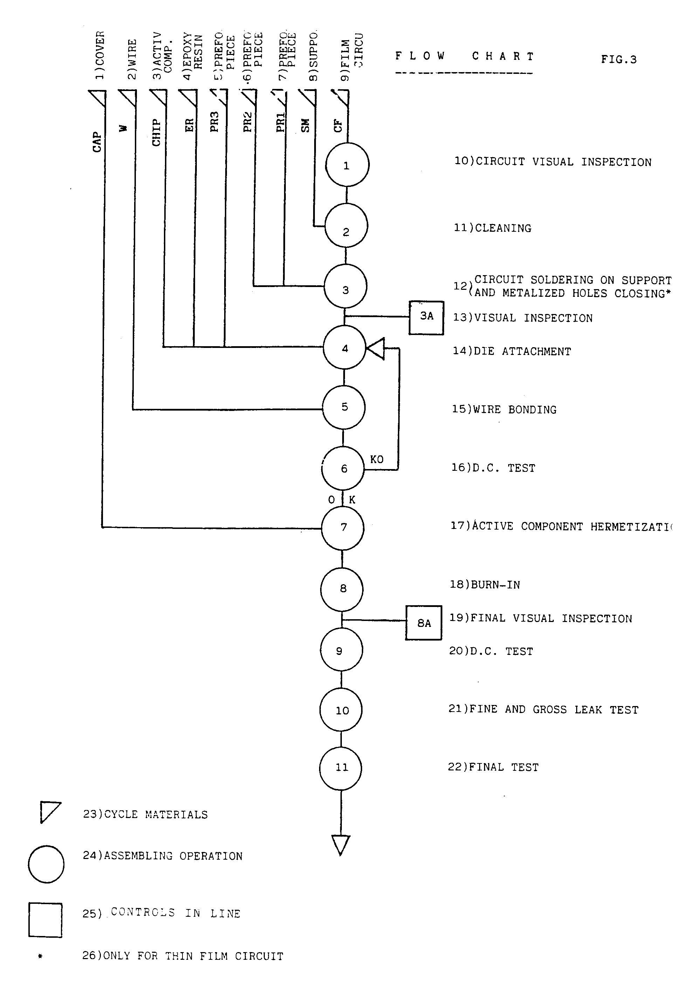

With reference, as not limited example, to the "flow chart" of the Figure 3, there are listed the machining phases and the materials used in the costruction of a typical hybrid film circuit that forms the object of the present invention.

The hybrid film circuit CF is controlled visually in 1 and in 2 it is washed together with the related support SM. In 3 it is fixed the rear side of the hybrid film circuit R.CF on the front side of the support F.SM (both CF and SM being washed) preferably by braze-welding or similar methods and contemporaneously closing, e.g. by welded metallic alloy and/or disks or cylinders, the metallized holes F1 and F2 of the hybrid film circuit CF; in the variant of the film circuits made by means of printing (thick film circuits) the holes F1 and F2 of the above mentioned circuit can be already closed.

In 3A it is made the visual control of this fastening.

In 4 it is made the "die attachment" fastening of the active component(s) CHIP on the seat S located on the rear side of the support R.SM or on the rear side of the hybrid film circuit R.CF in the variant of the Figures 2 and 2A. In 5 it is connected by "wire bonding" the active component(s) CHIP to the relevant flat zones, e.g. two P1 and P2, located on the rear side of the hybrid film circuit R.CF. In 6 it is made the test by D.C. of the active component(s) and the failed component(s) CHIP is/are removed and sent to 4. In 7 the cover CAP is, for example, welded onto the spot-facing L hermetizing the seat S and/or SP (variant Figure 2), in which it is inserted the active component(s) CHIP. In 8 it is made a "burn in" of the circuit object of the invention. The phases 7 and 8 can be also exchanged with one another. In 9 the hybrid film circuit object of the invention undergoes the test by D.C.. In 10 it is made the control of the hermetization "fine and gross leak" of the seat S or SP. In 11 it is made the final test, e.g. the static or functional test of the hybrid film circuit object of the invention.

### Reference numerals IN FIG. 3

- 1): COVER
- 2): WIRE
- 3): ACTIVE COMPONENTS
- 4): EPOXY RESIN
- 5): PREFORMED PIECE
- 6): PREFORMED PIECE
- 7): PREFORMED PIECE
- 8): SUPPORT
- 9): FILM CIRCUIT
- 10): CIRCUIT VISUAL INSPECTION
- 11): CLEANING
- 12): CIRCUIT SOLDERING ON SUPPORT AND METALIZED HOLES CLOSING
- 13): VISUAL INSPECTION
- 14): DIE ATTACHMENT
- 15): WIRE BONDING
- 16): D.C. TEST
- 17): ACTIVE COMPONENT HERMETIZATION
- 18): BURN-IN
- 19): FINAL VISUAL INSPECTION
- 20): D.C. TEST
- 21): FINE AND GROSS LEAK TEST
- 22): FINAL TEST
- 23): CYCLE MATERIALS
- 24): ASSEMBLING OPERATION
- 25): CONTROLS IN LINE
* ONLY FOR THE THIN FILM CIRCUITS

## Claims

1. Hybrid film circuit assembly consisting of a metallic support (SM) for supporting a hybrid film circuit (CF), said hybrid film circuit (CF) having relevant connection pads (P1, P2) and unpackaged active components (CHIP) thereon, characterized in that said active components are inserted in an unpackaged condition into at least one seat formed in the structure of the support and dimensioned substantially according to the dimension and number of said active components to be housed, whereby only said seat(s) is hermetically closed after the connection of the components to the relevant pads.

2. Hybrid film circuit assembly according to claim 1, characterized in that the metallic support includes the seats with relevant edges formed for housing the closing covers.

3. Hybrid film circuit assembly according to claim 1, characterized in that, for low dissipation powers the unpackaged active components (CHIP) are fixed directly on the rear side of the hybrid film circuit (R.CF).

4. Hybrid film circuit assembly according to claim 1, characterized in that, for high dissipation powers, the unpackaged active components are fixed into the seat of the metallic support (S).

5. Process for the fabrication of a hybrid film circuit assembly, according to any of the preceding claims, characterized in that it includes at least the following steps:
A) fixing, e.g. by Au/Sn or Au/Ge or Cu-Ag eutectic alloys, the hybrid film circuit rear side (R.CF) onto the front side of the support (F.SM), so that the pads (P1) and (P2) foreseen on the rear part of the hybrid film circuit (R.CF) are centered onto the holes (FP1) and (FP2) made on the metallic support (SM),
B) closing, e.g. by alloy and/or welded metallic disks or cylinders the metallized holes (F1) and (F2) of the hybrid film circuit (CF),
C) fixing, e.g. by resin or by welding, the active components (CHIP) into the seat (S) foreseen on the rear side of the metallic support (R.SM),
D) connecting by means of wire bonding the active components (CHIP) to the relevant pads (P1) and (P2) placed on the rear side of the hybrid film circuit (R.CF),
E) closing hermetically the seat (S and/or SP), e.g. by welding the cover (CAP) onto the spot-facing (L) formed on the rear side of the metallic support (R.SM).

6. Process according to claim 5, wherein the holes mentioned under B) are already closed when thick film circuits obtained by printing are used.

7. Process for the fabrication of a hybrid film circuit assembly according to claims 3 and 4, characterized in that the metallic support (SM) for the hybrid film circuit (CF), has at least a seat (S), e.g. of circular form, that is used contemporaneously as housing and as a die pad for the fastening of the active components (CHIP); in the seat (S) there are machined the through holes, (FP1 and FP2), through which it is possible to have an access to the pads (P1, P2) on the rear side of the hybrid film circuit (R.CF) for the connection of the active components (CHIP); and a spot-facing (L) concentric to the seat (S) for the housing of the cover (CAP) is made on the rear side of the metallic support (R.SM).

8. Process according to claim 5, wherein the seat (SP) extends through the metallic support (SM) and allows the active components (CHIP) to be fixed directly on the rear side of the hybrid film circuit (R.CF).

## Patentansprüche

1. Hybrid-Filmschaltungsanordnung, bestehend aus einem metallischen Träger (SM) zum Tragen einer Hybrid-Filmschaltung (CF), wobei die genannte Hybrid-Filmschaltung (CF) relevante Anschlußunterlagen (pad) (P₁, P₂) aufweist, und aus unbedeckten aktiven Komponenten (CHIP) hieran, dadurch **gekennzeichnet,** daß die genannten aktiven Komponenten in einem unbedeckten Zustand in mindestens einen Sitz eingeführt werden, der in der Struktur des Trägers ausgebildet ist und der Abmessung nach im wesentlichen der Abmessung und Zahl der aktiven Komponenten entspricht, die untergebracht werden müssen, wobei lediglich der genannte Sitz bzw. die genannten Sitze nach dem Anschluß der Komponenten an die entsprechenden Unterlagen hermetisch verschlossen wird bzw. werden.

2. Hybrid-Filmschaltungsanordnung nach Anspruch 1, dadurch **gekennzeichnet,** daß der metallische Träger die Sitze umfaßt, mit relevanten Kanten, die zur Aufnahme der verschließenden Abdeckungen ausgebildet sind.

3. Hybrid-Filmschaltungsanordnung nach Anspruch 1, dadurch **gekennzeichnet,** daß für niedrige Verbrauchsleistungen (dissipation powers) die unbedeckten aktiven Komponenten (CHIP) unmittelbar an der Rückseite der Hybrid-Filmschaltung (R.CF) befestigt sind.

4. Hybrid-Filmschaltungsanordnung nach Anspruch 1, dadurch **gekennzeichnet,** daß für hohe Verbrauchsleistungen (dissipation powers) die unbedeckten aktiven Komponenten im Sitz des metallischen Trägers (S) befestigt sind.

5. Verfahren für die Herstellung einer Hybrid-Filmschaltungsanordnung nach irgendeinem der vorangehenden Ansprüche, dadurch **gekennzeichnet,** daß es mindestens die folgenden Schritte aufweist:
A) Befestigen, beispielsweise durch eutektische Au/Sn oder Au/Ge- oder Cu-Ag-Legierungen der Hybrid-Filmschaltungs-Rückseite (R.CF) an der Frontseite des Trägers (F.SM), so daß die Unterlagen (P1) und (P2), die an dem hinteren Teil der Hybrid-Filmschaltung (R.CF) vorgesehen sind, auf die Löcher (FP1) und (FP2) zentriert sind, die am metallischen Träger (SM) hergestellt sind,
B) Verschließen, beispielsweise durch Legierung und/oder geschweißte Metallischeiben oder Zylinder, der metallisierten Löcher (F1) und (F2) der Hybrid-Filmschaltung (CF),
C) Befestigen, beispielsweise durch Harz oder durch Schweißen, der aktiven Komponenten (CHIP) in dem Sitz (S), der an der Rückseite des metallischen Trägers (R.SM) vorgesehen ist,
D) Anschließen mittels einer Draht-Verbindung der aktiven Vorrichtung (CHIP) an die relevanten Unterlagen (P1) und (P2), die an der Rückseite der Hybrid-Filmschaltung (R.CF) angeordnet sind,
E) hermetisches Verschließen der Sitze (S und/oder SP), beispielsweise durch Anschweißen der Abdeckung (CAP) auf der Ansenkung (L), die an der Rückseite des metallischen Trägers (R.SM) ausgearbeitet ist.

6. Verfahren nach Anspruch 5, worin die unter B) erwähnten Löcher bereits verschlossen sind, wenn gedruckte Dickfilmschaltungen für die Herstellung einer Hybrid-Filmschaltung benutzt werden.

7. Verfahren für die Herstellung einer Hybrid-Filmschaltung nach den Ansprüchen 3 und 4, dadurch **gekennzeichnet,** daß der Metallträger (SM) für die Hybrid-Filmschaltung (CF) mindestens einen beispielsweise kreisförmigen Sitz (S) aufweist, der gleichzeitig als Gehäuse und als Gesenkunterlage (die pad) zur Befestigung der aktiven Komponenten (CHIP) benutzt wird, daß in den Sitz (S) Durchgangslöcher (FP1 und FP2) spanend eingebracht werden, durch welche es möglich ist, Zugang zu den Unterlagen (P1, P2) an der Rückseite der Hybrid-Filmschaltung (R.CF) für den Anschluß der aktiven Komponenten (CHIP) zu haben, und daß eine Ansenkung (L) konzentrisch zum Sitz (S) für die Aufnahme der Abdeckung (CAP) an der Rückseite des metallischen Trägers vorgenommen wird.

8. Verfahren nach Anspruch 5, worin der Sitz (SP) sich durch den metallischen Träger (SM) hindurch erstreckt und es der aktiven Komponente (CHIP) gestattet, unmittelbar an der Rückseite der Hybrid-Filmschaltung (R.CF) befestigt zu werden.

## Revendications

1. Assemblage de circuit hybride à couche mince constitue par un support métallique (SM) pour supporter un circuit hybride à couche mince (CF), ledit circuit hybride à couche mince (CF) ayant des plots de connexion correspondants (P1, P2), et des composants actifs (CHIP) non encapsulés disposés sur celui-ci, caractérisé en ce que lesdits composants actifs sont insérés, sans être encapsulés, dans au moins un logement formé dans la structure du support et dimensionné sensiblement en fonction des dimensions et du nombre desdits composants actifs à loger, grâce à quoi seul(s) ledit(lesdits) logement(s) est(sont) hermétiquement fermé(s) après que les composants ont été connectés aux plots correspondants.

2. Assemblage de circuit hybride à couche mince selon la revendication 1, caractérisé en ce que le support métallique comporte les logements avec des bords correspondants formés pour loger les capots de fermeture.

3. Assemblage de circuit hybride à couche mince selon la revendication 1, caractérisé en ce que, pour de faibles puissances de dissipation, les constituants actifs (CHIP) non encapsulés sont fixés directement sur la face postérieure (R.CF) du circuit hybride à couche mince.

4. Assemblage de circuit hybride à couche mince selon la revendication 1, caractérisé en ce que, pour de fortes puissances de dissipation, les composants actifs non encapsulés sont fixés dans le logement ménagé dans le support métallique (S).

5. Procédé pour la fabrication d'un assemblage de circuit hybride à couche mince selon l'une quelconque des revendications précédentes, caractérisé en ce qu'il comporte au moins les étapes suivantes:
A) fixation, par exemple a' l'aide d'alliages eutectiques Au-Sn ou Au-Ge ou Cu-Ag, de la face postérieure (R.CF) du circuit hybride à couche mince sur la face antérieure (F.SM) du support de façon que les plots (P1) et (P2) prévus sur la partie postérieure (R.CF) du circuit hybride à couche mince soient centrés sur les trous (FP1) et (FP2) ménagés sur le support métallique (SM),
B) Fermeture, par exemple à l'aide de disques ou cylindres métalliques en alliage et/ou soudés, des trous métallisés (F1) et (F2) du circuit hybride à couche mince (CF),
C) fixation, par exemple à l'aide de résine ou par soudage, des composants actifs (CHIP) dans le logement (S) prévu sur la face postérieure (R.SM) du support métallique,
D) connexion, par métallisation, des composants actifs (CHIP) aux plots correspondants (P1) et (P2) placés sur la face postérieure du circuits hybride à couche mince (R.CF),
E) fermeture hermétique du logement (S et/ou SP), par exemple en soudant le capot (CAP) sur le lamage (L) formé sur la face postérieure (R.SM) du support métallique.

6. Procédé selon la revendication 5, dans lequel les trous cités en B) sont déjà fermés si on utilise des circuits hybrides épais obtenus par impression.

7. Procédé pour la fabrication d'un assemblage de circuit hybride à couche mince selon les revendications 3 et 4, caractérisé en ce que le support métallique (SM) pour le circuit hybride à couche mince (CF) a au moins un logement (S), par exemple de forme circulaire, servant simultanément de boîtier et de face de soudage pour la fixation des composants actifs (CHIP); dans le logement (S) sont usinés les trous traversants (FP1 et FP2) par lesquels il est possible d'avoir accès aux plots (P1, P2) sur la face postérieure (R.CF) du circuit hybride à couche mince pour la connexion des composants actifs (CHIP); et un lamage (L) concentrique avec le logement (S) pour recevoir le capot (CAP) est réalisé sur la face postérieure (R. SM).

8. Procédé selon la revendication 5, dans lequel le logement (SP) s'étend à travers le support métallique (SM) et permet de fixer les composants actifs (CHIP) directement sur la face postérieure (R.CF) du circuit hybride à couche mince.
